# EUROPÄISCHE PATENTSCHRIFT

(11) **EP 1 525 428 B1**
(45) Veröffentlichungstag und Bekanntmachung des Hinweises auf die Patenterteilung: **21.12.2005**
(21) Anmeldenummer: 04729819.5
(22) Anmeldetag: 28.04.2004
(51) Int. Cl.: F28F 3/12, F28F 7/02

(54) **VERFAHREN ZUR ERSTELLUNG EINES HYDRAULIKNETZWERKES FÜR EINEN OPTIMIERTEN WÄRMEÜBERTRAGUNGS- UND STOFFTRANSPORT**
METHOD FOR THE CREATION OF A HYDRAULIC NETWORK USED FOR OPTIMIZED HEAT TRANSFER AND MATERIAL CONVEYANCE
PROCEDE DE FABRICATION D'UN RESEAU HYDRAULIQUE POUR UNE TRANSMISSION DE CHALEUR ET UN TRANSPORT DE MATIERE OPTIMISES

(30) Priorität: 29.04.2003 DE 10319367
(43) Veröffentlichungstag der Anmeldung: 27.04.2005
(73) Patentinhaber: Fraunhofer-Gesellschaft zur Förderung der angewandten Forschung e.V., 80686 München (DE)
(72) Erfinder: HERMANN, Michael, 79110 Freiburg (DE)
(74) Vertreter: Gagel, Roland
(86) Internationale Anmeldenummer: PCT/DE2004/000886
(87) Internationale Veröffentlichungsnummer: WO 2004/097323

(56) Entgegenhaltungen:
- WO-A-01/95688
- US-A- 6 145 804

## Beschreibung

### Technisches Anwendungsgebiet

Die vorliegende Erfindung betrifft ein Verfahren zur Erstellung eines Hydrauliknetzwerkes zur Wärme-und/oder Stoffübertragung, bei dem eine vorgegebene Übertragungsfläche oder ein vorgegebenes Übertragungsvolumen mit einem mehrfach verzweigten Hydrauliknetzwerk versehen wird.

Der Wärmetransport mit Fluiden stellt eine wichtige technische Aufgabe sowohl bei konventionellen Wärmetauschern als auch bei der Nutzung erneuerbarer Energien dar, so beispielsweise bei der Übertragung der absorbierten Solarstrahlung auf das Wärmeträgermedium in einem Sonnenkollektor als auch bei der Abgabe dieser Energie an einen Speicher. Bei der energetischen Betrachtung solcher Systeme muss sowohl die thermische Effizienz bei der Wärmeübertragung als auch die für den Fluidtransport benötigte hydraulische Leistung berücksichtigt werden. Um Wärme von einer Wärmeübertragungsfläche auf eine Kanalstruktur zu übertragen, müssen die Kanäle möglichst gleichmäßig auf diese Fläche verteilt werden.

Aus dem Stand der Technik sind bereits zahlreiche Hydrauliknetzwerke bekannt, bei denen die Kanäle relativ gleichmäßig auf die Wärmeübertragungsfläche verteilt sind. Siehe insbesondere WO 01/95688. So sind beispielsweise Wärmeübertragungssysteme bekannt, bei denen die Fluidkanäle mäanderförmig über die Fläche verlaufen. Eine derartige Ausgestaltung wird auch als Serpentinenabsorber bezeichnet. Weiterhin sind beispielsweise auf dem Gebiet der Solartechnik so genannte Harfenabsorber bekannt, bei denen die Kanäle parallel zueinander angeordnet sind und auf der Ein- und Austrittsseite in Sammelkanäle münden. Eine weitere bekannte Ausgestaltung ist der so genannte Kissenabsorber, bei dem das Fluid eine die Wärmeübertragungsfläche begrenzende flache Kammer durchströmt, so dass es vollflächig mit der Wärmeübertragungsfläche in Kontakt ist.

Diese bisher bekannten Konstruktionen sind jedoch häufig mit Nachteilen verbunden. So können bei mäanderförmig angeordneten Fluidkanälen hohe Druckverluste entstehen, die eine hohe Pumpleistung erfordern. Eine Parallelanordnung von Kanälen kann aufgrund der Druckverluste beim Übergang des Fluids von den Sammelkanälen in die parallelen Kanäle bzw. umgekehrt zu einer ungleichmäßigen Volumenstromverteilung und damit zu entsprechenden Temperaturunterschieden auf der Wärmeübertragungsfläche führen. Bei vollflächigen Konstruktionen besteht schließlich die Gefahr, dass einzelne Bereiche der Kammer schlecht oder gar nicht durchströmt werden. Bei den letztgenannten Systemen ist zudem die Wärmekapazität aufgrund des größeren Fluidinhalts in der Regel höher als bei kanalartigen Systemen, was sich negativ auf das dynamische Verhalten auswirken kann.

Aus der EP 0 857 554 A2 sind Formen und Werkzeuge mit einem feingliedrig verzweigten Temperierkanalnetzwerk bekannt, das in der Art eines arteriellen Gefäßsystems aufgebaut ist. In einer in der Druckschrift dargestellten Ausgestaltung wird hierfür ein binär verzweigtes Hydrauliknetzwerk eingesetzt. Ein grundsätzliches Problem besteht jedoch in der Erstellung eines derartigen verzweigten Hydrauliknetzwerkes, so dass es die Wärmeübertragungsfläche bzw. das Wärmeübertragungsvolumen möglichst gleichmäßig durchsetzt. Durch die in der Druckschrift angegebene Vorgehensweise, in der Natur vorkommende Verzweigungsarten als Vorbild zu nehmen, wird die Erstellung eines derartigen Netzwerkes deutlich erschwert.

Ausgehend von diesem Stand der Technik besteht die Aufgabe der vorliegenden Erfindung darin, ein Verfahren zur Erstellung eines Hydrauliknetzwerkes zur Wärme-und/oder Stoffübertragung anzugeben, das sich bei beliebigen Geometrien der Übertragungsfläche bzw. des Übertragungsvolumens einfach durchführen lässt und einen optimierten Wärmeübertragungs- und Stofftransport ermöglicht.

### Darstellung der Erfindung

Die Aufgabe wird mit dem Verfahren gemäß Patentanspruch 1 gelöst. Vorteilhafte Ausgestaltungen des Verfahrens sind Gegenstand der Unteransprüche oder lassen sich aus der nachfolgenden Beschreibung sowie dem Ausführungsbeispiel entnehmen.

Bei dem vorliegenden Verfahren zur Erstellung eines Hydrauliknetzwerkes zur Wärme- und/oder Stoffübertragung, bei dem eine vorgegebene Übertragungsfläche oder ein vorgegebenes Übertragungsvolumen mit einem mehrfach, vorzugsweise binär, verzweigten Hydrauliknetzwerk versehen wird, wird der Verlauf des Hydrauliknetzwerkes durch folgende Schritte festgelegt:
- Festlegen eines Fluideintrittspunktes und eines Fluidaustrittspunktes;
- Legen eines ersten Pfades zwischen Fluideintritts-und Fluidaustrittspunkt mit annähernd gleichem Abstand zu seitlichen Begrenzungen der Übertragungsfläche oder des Übertragungsvolumens;
- Festlegen von ersten Verzweigungsstartpunkten und - endpunkten an Stellen des ersten Pfades, an denen ein vorgebbarer Höchstabstand zu den seitlichen Begrenzungen überschritten bzw. ein vorgebbarer Mindestabstand unterschritten wird, in einem ersten Iterationsschritt;
- Verbinden der ersten Verzweigungsstartpunkte und - endpunkte durch Legen jeweils zumindest zweier zweiter Pfade mit annähernd gleichem Abstand zu nächstliegenden seitlichen Begrenzungen der Übertragungsfläche oder des Übertragungsvolumens und dem ersten Pfad;
- Festlegen von weiteren Verzweigungsstartpunkten und - endpunkten an Stellen der jeweils unmittelbar vorangehend gelegten Pfade, an denen ein vorgebbarer Höchstabstand zu nächstliegenden seitlichen Begrenzungen der Übertragungsfläche oder des Übertragungsvolumens überschritten bzw. ein vorgebbarer Mindestabstand unterschritten wird, in einem weiteren Iterationsschritt;
- Verbinden der weiteren Verzweigungsstartpunkte und - endpunkte durch Legen jeweils zumindest zweier weiterer Pfade mit annähernd gleichem Abstand zu nächstliegenden seitlichen Begrenzungen der Übertragungsfläche oder des Übertragungsvolumens und einem nächstliegenden der bisher gelegten Pfade; und
- gegebenenfalls Wiederholung des weiteren Iterationsschrittes, bis eine vorgebbare Anzahl von Iterationsschritten oder ein vorgebbarer Mindestabstand der als Letztes gelegten Pfade zu den nächstliegenden seitlichen Begrenzungen der Übertragungsfläche oder des Übertragungsvolumens erreicht ist. Die nach Beendigung der Iterationsschritte im letzten Iterationsschritt erhaltenen Pfade sowie deren Verbindung mit dem Fluideintritts- und Fluidaustrittspunkt über Teile der bisher gelegten Pfade legen die Struktur des Hydrauliknetzwerkes fest, das anschließend entsprechend gefertigt wird.

Vorzugsweise wird als Hydrauliknetzwerk bei einer vorgegebenen Übertragungsfläche ein binäres Netzwerk und bei einem vorgegebenen Übertragungsvolumen ein ternäres Netzwerk gebildet, so dass an jeder Verzweigung ein Kanal in entweder zwei oder drei Pfade bzw. Kanäle verzweigt. Mit einer idealen Verzweigungsstruktur teilt sich der Volumenstrom des Fluids an jedem Verzweigungspunkt jeweils zur Hälfte auf den rechten und linken Kanal auf. Dies geschieht in allen Iterationsstufen, also bei jeder weiteren Verzweigung, so dass eine gleichmäßige Volumenstromverteilung entsteht. Gleichzeitig sind die Verzweigungswinkel nur verhältnismäßig klein, so dass die Strömung nur sanft umgelenkt wird, die einzelnen Kanäle annähernd parallel zueinander verlaufen und der Druckverlust gering ist. Bei manchen konkreten Anwendungen gibt es aufgrund einer asymmetrischen Übertragungsfläche zwangsläufig leichte Abweichungen von diesem vorzugsweisen Idealfall.

Vorzugsweise werden die Durchmesser bzw. die Querschnitte der mit jeder Verzweigung neu gebildeten Kanäle der Hydraulikstruktur jeweils so gewählt, dass sich der Volumenstrom an jeder Verzweigung zu gleichen Teilen auf die neu gebildeten Kanäle aufteilt. Die Durchmesser der einzelnen Kanäle können dabei unterschiedlich ausfallen, falls unterschiedliche Längen der neu gebildeten Kanäle kompensiert werden müssen.

Selbstverständlich lässt sich jedoch auch eine andere Verteilung der Kanalquerschnitte an den Verzweigungen wählen, falls dies für eine Optimierung der Wärmeübertragung sowie eine Minimierung Druckverluste bei einem vorgegebenen Übertragungsvolumen oder einer vorgegebenen Übertragungsfläche erforderlich ist.

Vorzugsweise werden die Vernetzungsparameter des Hydrauliknetzwerkes bei der Durchführung des vorliegenden Verfahrens mit einem Optimierungsverfahren variiert, um die für die jeweilige Anwendung optimalen Vernetzungsparameter zu erhalten. Als Vernetzungsparameter kommen hierbei beispielsweise die Mindest-und Höchstabstände, die Positionen von Fluideintritts-und Fluidaustrittspunkt, die Zahl der Iterationsschritte und/oder das Verhältnis der Durchmesser der Kanäle der Hydraulikstruktur vor und nach jeder Verzweigung in Frage. Hierbei können sowohl einzelne als auch beliebige Kombinationen dieser Vernetzungsparameter dem Optimierungsverfahren unterzogen werden. Bei dem Optimierungsverfahren werden die Vernetzungsparameter ausgehend von einem vorgegebenen Startparametersatz variiert und damit verschiedene Geometrien der Hydraulikstruktur erzeugt. Diese unterschiedlichen Geometrien werden durch thermische und hydraulische Simulationen hinsichtlich ihrer Gesamteffizienz berechnet. Die Gesamteffizienz ergibt sich dabei aus einer Berechnung der thermischen Effizienz und der hydraulischen Leistung. Beide Berechnungen können mit einem so genannten CFD-Programm (Computational Fluid Dynamics) oder mit anderen vereinfachten Simulationswerkzeugen durchgeführt werden. Die Parameter der besten Variante oder eine Kombination von Parametern aus mehreren der Varianten wird als neuer Startparametersatz verwendet. Von diesen werden wiederum neue Varianten erzeugt usw.. Durch dieses Optimierungsverfahren, beispielsweise das Optimierungsverfahren der "Evolutionsstrategie", können insbesondere vielparametrische Probleme, für die es keine analytische Gesamtbeschreibung gibt, gelöst werden.

Das Verfahren zur Erstellung der Hydraulikstrukturen lässt sich beispielsweise für Anwendungen in Sonnenkollektoren, Heiz- und Kühlelementen jeglicher Art und Größe, Latentwärmespeichern oder Brennstoffzellen, um nur einige zu nennen, einsetzen. Insbesondere dreidimensionale Hydrauliknetzwerke können beispielsweise in Sorptionswärmespeichern eingesetzt werden, bei denen sowohl der Wärme- als auch der Stofftransport möglichst gleichmäßig im Raum erfolgen soll. Dabei soll jedoch das Speichervolumen nur minimal eingeschränkt werden, so dass Strukturen benötigt werden, die bei geringem Eigenvolumen möglichst den gesamten Raum bedienen können. Ebenso kann das vorliegende Verfahren zum Erzeugen von Strömungskanälen für den Stofftransport (Reaktionsgase und entstehendes Wasser) in Brennstoffzellen eingesetzt werden.

Ein besonderer Vorteil des vorliegenden Verfahrens besteht darin, dass es sich nach Vorgabe des Fluideintritts- und Fluidaustrittspunktes sowie der entsprechenden Höchst- bzw. Mindestabstände und/oder Iterationen ebenso wie beim zusätzlichen Einsatz des Optimierungsverfahrens vollkommen automatisiert durchführen lässt.

Zur technischen Umsetzung sind verschiedene Herstellverfahren nutzbar, so beispielsweise Prägen, Gießen, Rollbond, Fräsen oder Laminieren. Auch bekannte Rapid-Prototyping-Verfahren eignen sich selbstverständlich zum Herstellen des Hydrauliknetzwerkes. Ebenso können diverse Materialien zum Einsatz kommen, wie beispielsweise Kunststoff, Metall, Epoxydharz, Gießkeramik und andere.

### Kurze Beschreibung der Zeichnungen

Das vorliegende Verfahren wird nachfolgend anhand eines Ausführungsbeispiels in Verbindung mit den Zeichnungen nochmals kurz erläutert. Hierbei zeigen:
- Fig. 1: eine Gegenüberstellung von zwei bekannten Hydraulikstrukturen des Standes der Technik mit einem nach dem vorliegenden Verfahren erstellten Hydrauliknetzwerk;
- Fig. 2: verschiedene Schritte bei der Durchführung des vorliegenden Verfahrens;
- Fig. 3: ein Beispiel zur Darstellung des in einer Ausgestaltung des Verfahrens eingesetzten Glättungsalgorithmus; und
- Fig. 4: unterschiedliche Hydraulikstrukturen, die mit unterschiedlichen Vernetzungsparametern des vorliegenden Verfahrens erstellt wurden.

### Wege zur Ausführung der Erfindung

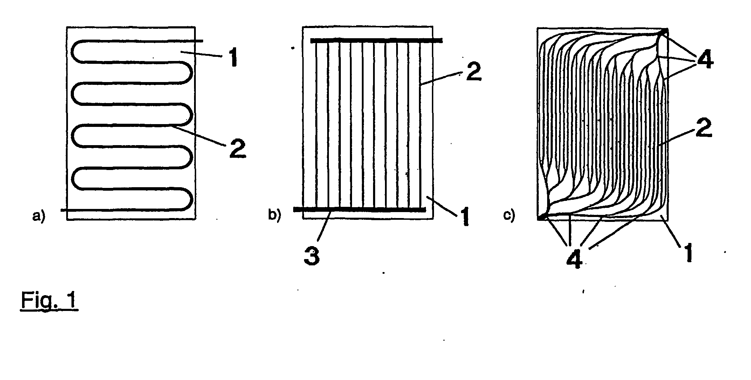

Fig. 1 zeigt beispielhaft eine Gegenüberstellung zwischen zwei bekannten Hydraulikstrukturen und einer mit dem vorliegenden Verfahren erstellten Hydraulikstruktur.
In Teilabbildung a) ist die bekannte mäanderförmige Anordnung eines Fluidkanals 2 an einer Wärmeübertragungsfläche 1 zu erkennen. In einer derartigen Struktur können allerdings hohe Druckverluste entstehen.
Teilabbildung b) zeigt eine parallele Anordnung von Strömungskanälen 2, die jeweils in Sammelkanäle 3 münden. Bei dieser Ausgestaltung können aufgrund der Druckverluste beim Übergang von den Sammelkanälen 3 bzw. in die Sammelkanäle 3 ungleichmäßige Volumenstromverteilungen auftreten.

Teilabbildung c) zeigt schließlich ein mehrfach verzweigtes Hydrauliknetzwerk, das mit dem vorliegenden Verfahren erstellt wurde. Hierbei sind sehr gut die einzelnen Verzweigungen 4 zu erkennen, an denen der Fluidstrom jeweils in zwei Teilkanäle 2 aufgeteilt wird. Aufgrund der kleinen Winkel dieser Verzweigungen sowie der guten Ausfüllung der Wärmeübertragungsfläche 1 durch die einzelnen Teilkanäle 2 kommt es einerseits zu sehr geringen Druckverlusten und andererseits zu einer hohen thermischen Effizienz bei der Wärmeübertragung von der oder auf die Wärmeübertragungsfläche 1.

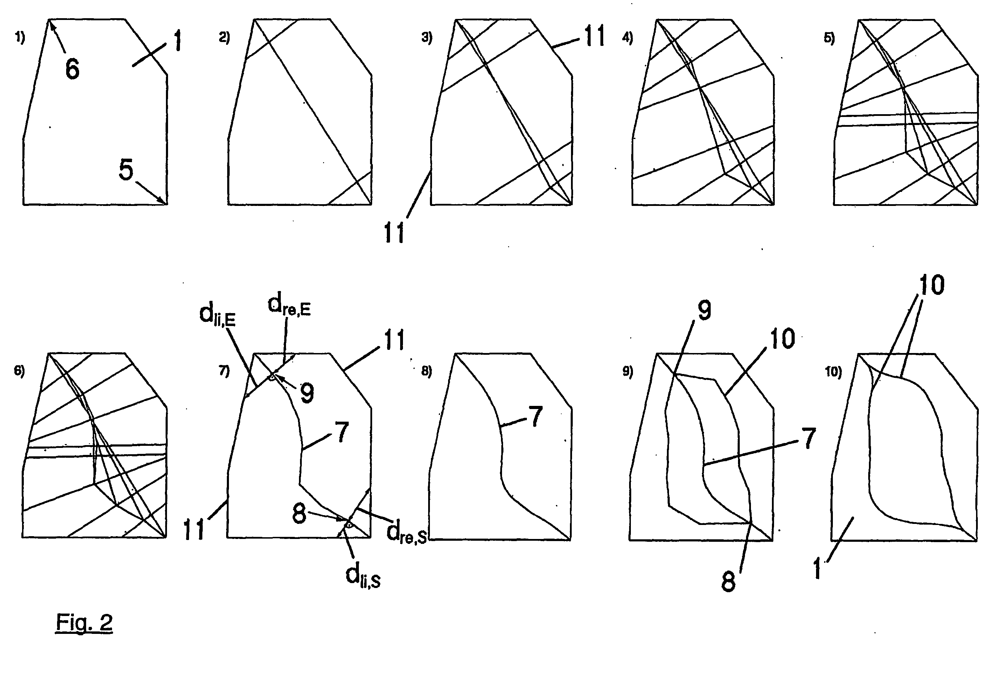

Fig. 2 zeigt beispielhaft eine Möglichkeit zum Erstellen eines derartigen mehrfach verzweigten Hydrauliknetzwerkes gemäß dem vorliegenden Verfahren.

Zunächst werden der Fluideintritts- 5 und Fluidaustrittspunkt 6 an der Übertragungsfläche 1 festgelegt (Teilabbildung 1). Diese Punkte werden miteinander verbunden. Anschließend werden von beiden Punkten 5, 6 aus jeweils im Abstand sₒ (vorgegebene Schrittweite) die Senkrechten auf der entstandenen Strecke bestimmt (Teilabbildung 2). Diese Senkrechten schneiden den Rand 11 der Übertragungsfläche 1 in jeweils zwei Punkten. Die Strecke zwischen diesen Schnittpunkten wird halbiert. Die Verbindung vom Fluideintritts- 5 und Fluidaustrittspunkt 6 zu diesem Mittelpunkt bilden jeweils das erste Teilstück des ersten Pfades 7 (von zwei Seiten aus betrachtet). Nun werden diese Verfahrensschritte - ausgehend von den neu entstandenen Punkten, also den Mittelpunkten - wiederholt: Bildung der Verbindungsstrecke, der Senkrechten, Mittelpunktbestimmung, neues Pfadstück des ersten Pfades 7 (Teilabbildung 3)).

Diese Vorgehensweise wird wiederholt, bis der Abstand der Punkte gering genug geworden ist (Teilabbildungen 4 bis 6). Schließlich werden die letzten Punkte miteinander verbunden. Das Ziel bei der Ermittlung dieses ersten Pfades 7 besteht darin, einen möglichst gleichen Abstand zum rechten und linken Rand 11 der Übertragungsfläche 1 zu erreichen.

Im nächsten Schritt (Teilabbildung 7) wird der Start- und Endpunkt für die nächste Iteration, d.h. die erste Verzweigung, bestimmt. Hierzu verfolgt man in Strömungsrichtung Teilstück für Teilstück des erzeugten ersten Pfades 7 (0. Iterationsstufe) und ermittelt jeweils die Abstände zum rechten und linken Rand 11 (dᵣₑ bzw. dₗᵢ). Sobald einer dieser Abstände über einem vorgegebenen Maximalwert d_{max,0} liegt, wird der Startpunkt 8 für die erste Verzweigung gesetzt. Nun läuft man auf dem Pfad weiter, bis einer der beiden Abstände unter einem vorgegebenen Minimalwert d_{min,0} (z.B. d_{min,0} = 0,8 ·d_{max,0}) liegt. Dort wird der Endpunkt 9 der Verzweigung gesetzt. Je nach Form der Fläche können auch mehrere Verzweigungen auftreten, beispielsweise vor und nach einer Einschnürung. Nach Bestimmung der Verzweigungspunkte 8, 9 wird der erste Pfad 7 geglättet (Teilabbildung 8).

Nun wird das Verfahren analog zu den beschriebenen Schritten in der vorangehenden 0. Iterationsstufe - beginnend bei den zuvor berechneten Start- und Endpunkten 8, 9 - durchgeführt (Teilabbildung 9). Zunächst werden dazu wiederum die Punkte 8, 9 verbunden und die Senkrechten im Abstand s₁ bestimmt (der Index bezeichnet die Iterationsstufe; die Schrittweite s kann sich in jeder Iteration ändern). Die jeweilige Senkrechte schneidet den ersten Pfad 7 der 0. Iterationsstufe. Mit diesem entstehendem Schnittpunkt und den Schnittpunkten mit dem Rand 11 wird die Senkrechte in eine rechte und eine linke Strecke geteilt. Die Verbindung vom Start- 8 bzw. Endpunkt 9 zu den Mittelpunkten dieser Strecken bilden die ersten Teilstücke auf den Pfaden 10 der ersten Iterationsstufe (rechter und linker Pfad 10). Das Verfahren wird entsprechend fortgesetzt, wobei nun die rechte bzw. linke Teilfläche als Begrenzung berücksichtigt werden. Sobald die Pfade 10 der ersten Iterationsstufe erzeugt und die neuen Start- und Endpunkte ermittelt worden sind, wird wiederum - unter Berücksichtigung des Übergangs zum ersten Pfad 7 der 0. Iterationsstufe - der Glättungsalgorithmus angewandt (Teilabbildung 10).

Die beschriebenen Schritte werden fortgesetzt, bis eine vorgegebene Iterationstiefe oder ein Abbruchkriterium (z.B. ein minimaler Pfadabstand) erreicht wurde.

Die Änderung des Kanalquerschnitts von einer Iterationsstufe zur nächsten stellt einen weiteren Parameter dar, der das Strömungsverhalten beeinflusst. Gegebenenfalls kann er sich auch innerhalb einer Iterationsstufe - d.h. bei parallelen Kanälen - unterscheiden, um unterschiedliche Kanallängen auszugleichen (hydraulischer Abgleich).

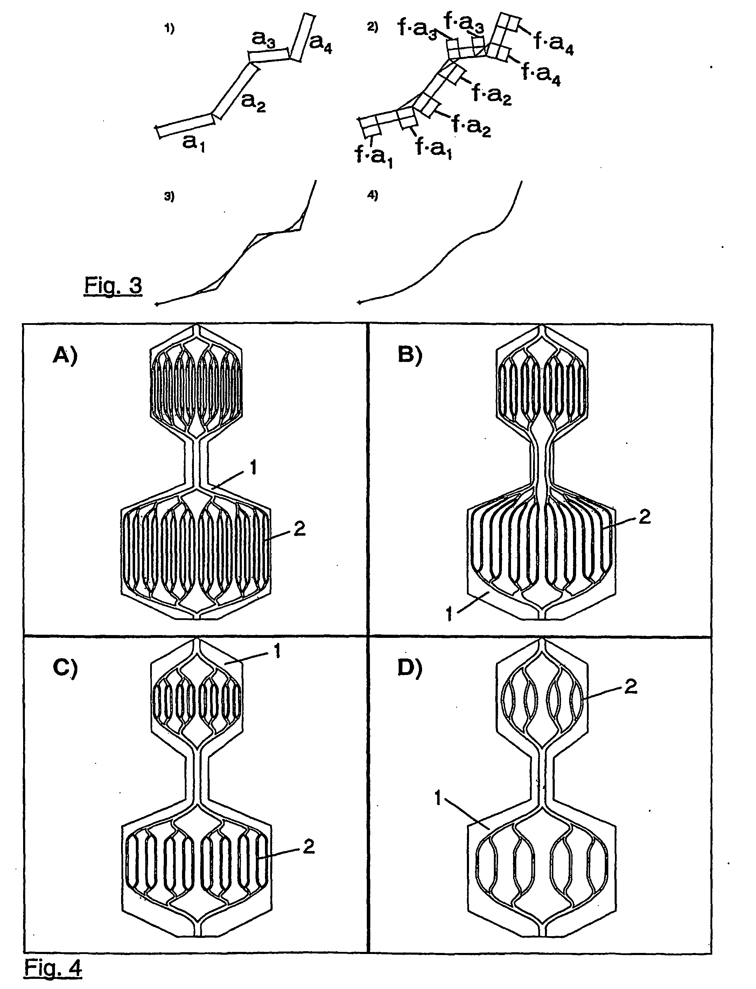

Die Funktionsweise des in diesem Beispiel eingesetzten Glättungsalgorithmus soll exemplarisch anhand von Fig. 3 erklärt werden. Ausgehend von dem in Teilabbildung 1 dargestellten Pfad, der aus Teilstücken der Längen a₁-a₄ besteht, werden zunächst für jedes Teilstück neue Punkte bestimmt, die jeweils den Abstand f · aᵢ vom Anfangs- bzw. Endpunkt jedes Teilstücks haben, wobei f ein voreingestellter Faktor ist (günstig ist z.B. f = 0,3). Auf diese Weise wird jedes Teilstück in drei Teile geteilt. Im ersten Glättungsschritt werden nun diese neuen Punkte miteinander verbunden, so dass nur die Mittelteile der ursprünglichen Teilstücke übernommen und die bisherigen Ecken ignoriert werden (Teilabbildung 2). Dieses Verfahren wird mit dem jeweils neu entstandenen Pfad wiederholt, bis die gewünschte Glättung erreicht ist (Teilabbildungen 3 und 4) .

Fig. 4 zeigt exemplarisch den Einfluss der Vernetzungsparameter auf das Aussehen der erzeugten Hydraulikstrukturen. So wurden in den Varianten A) bis D) die Schrittweite s₀, der Faktor fₛ (sᵢ₊₁= fₛ · sᵢ), der Maximalabstand d_{max, 0,} der Faktor f_{d} (d_{max, i+1} =f _{d} · d_{max,i}) sowie die Anzahl der Iterationen n variiert. Der oben beschriebene Faktor f für den Glättungsalgorithmus war in allen Fällen gleich (f=0,3). Es ist erkennbar, dass je nach Wahl der Parameter entweder die Flächenausnutzung (Variante A) oder die günstige Hydraulik durch kleine Winkel bei Strömungsumlenkungen (Variante D) im Mittelpunkt stehen. Für die jeweilige Anwendung gilt es, die besten Parameter im Hinblick auf die Gesamteffizienz zu finden.

Auch wenn in dem vorangehenden Ausführungsbeispiel lediglich eine zweidimensionale Hydraulikstrutur erläutert wurde, so sind selbstverständlich mit dem vorliegenden Verfahren auch dreidimensionale, baumartige Strukturen realisierbar. Hierbei kann beispielsweise analog zum Mittelpunkt einer Strecke im zweidimensionalen Fall der Schwerpunkt einer Schnittfläche im dreidimensionalen Fall bestimmt werden. Statt der rechten und linken Teilstrecke im zweidimensionalen Fall, wie dies anhand der Fig. 2 erläutert wurde, werden hier beispielsweise drei flächengleiche Teilflächen berücksichtigt. Entsprechend verzweigt sich in diesem Beispiel dann ein Kanal an einem Verzweigungspunkt in drei Teilkanäle. Die damit erzeugbare dreidimensionale Hydraulikstruktur erzeugt die gleichen Vorteile an einem Übertragungsvolumen wie dies mit der zweidimensionalen Hydraulikstruktur an einer Wärmeübertragungsfläche erreicht wird.

| **BEZUGSZEICHENLISTE** | |
|---|---|
| 1 | Wärmeübertragungsfläche |
| 2 | Kanäle der Hydraulikstruktur |
| 3 | Sammelkanal |
| 4 | Verzweigungspunkte |
| 5 | Fluideintrittspunkt |
| 6 | Fluidaustrittspunkt |
| 7 | erster Pfad |
| 8 | Verzweigungsstartpunkt |
| 9 | Verzweigungsendpunkt |
| 10 | Pfad |
| 11 | Seitliche Begrenzungen |

## Patentansprüche

1. Verfahren zur Erstellung eines Hydraulik-Netzwerkes zur Wärme- und/oder Stoffübertragung, bei dem eine vorgegebene Übertragungsfläche (1) oder ein vorgegebenes Übertragungsvolumen mit einem mehrfach verzweigten Hydrauliknetzwerk versehen wird,
**dadurch gekennzeichnet,**
**dass** der Verlauf des Hydrauliknetzwerkes durch folgende Schritte festgelegt wird:
- Festlegen eines Fluideintrittspunktes (5) und eines Fluidaustrittspunktes (6);
- Legen eines ersten Pfades (7) zwischen Fluideintritts- (5) und Fluidaustrittspunkt (6) mit annähernd gleichem Abstand zu seitlichen Begrenzungen (11) der Übertragungsfläche (1) oder des Übertragungsvolumens;
- Festlegen von ersten Verzweigungsstartpunkten (8) und -endpunkten (9) an Stellen des ersten Pfades (7), an denen ein vorgebbarer Höchstabstand zu den seitlichen Begrenzungen (11) überschritten bzw. ein vorgebbarer Mindestabstand unterschritten wird, in einem ersten Iterationsschritt;
- Verbinden der ersten Verzweigungsstartpunkte (8) und -endpunkte (9) durch Legen jeweils zumindest zweier zweiter Pfade (10) mit annähernd gleichem Abstand zu nächstliegenden seitlichen Begrenzungen (11) der Übertragungsfläche (1) oder des Übertragungsvolumens und dem ersten Pfad (7);
- Festlegen von weiteren Verzweigungsstartpunkten (8) und -endpunkten (9) an Stellen der jeweils unmittelbar vorangehend gelegten Pfade (10), an denen ein vorgebbarer Höchstabstand zu nächstliegenden seitlichen Begrenzungen (11) der Übertragungsfläche (1) oder des Übertragungsvolumens überschritten bzw. ein vorgebbarer Mindestabstand unterschritten wird, in einem weiteren Iterationsschritt;
- Verbinden der weiteren Verzweigungsstartpunkte (8) und -endpunkte (9) durch Legen jeweils zumindest zweier weiterer Pfade (10) mit annähernd gleichem Abstand zu nächstliegenden seitlichen Begrenzungen (11) der Übertragungsfläche (1) oder des Übertragungsvolumens und einem nächstliegenden der bisher gelegten Pfade (7, 10); und
- Wiederholung des weiteren Iterationsschrittes, bis eine vorgebbare Anzahl von Iterationsschritten oder ein vorgebbarer Mindestabstand der als Letztes gelegten Pfade zu den nächstliegenden Begrenzungen (11) der Übertragungsfläche (1) oder des Übertragungsvolumens erreicht ist;
wobei nach Beendigung der Iterationsschritte die jeweils im letzten Iterationsschritt gelegten Pfade (10) sowie deren Verbindung mit dem Fluideintritts- (5) und Fluidaustrittspunkt (6) über Teile der bisher gelegten Pfade die Struktur des Hydrauliknetzwerkes festlegen.

2. Verfahren nach Anspruch 1,
**dadurch gekennzeichnet,**
**dass** ein Optimierungsverfahren eingesetzt wird, bei dem ein oder mehrere Vernetzungsparameter des Hydrauliknetzwerkes variiert werden, um für vorgegebene Anwendungen optimale Vernetzungs-parameter zur Festlegung des Verlaufs und der Dimensionierung des Hydrauliknetzwerkes zu erhalten.

3. Verfahren nach Anspruch 2,
**dadurch gekennzeichnet,**
**dass** als Vernetzungsparameter die Mindest- und Höchstabstände variiert werden.

4. Verfahren nach Anspruch 2 oder 3,
**dadurch gekennzeichnet,**
**dass** als Vernetzungsparameter die Zahl der Iterationsschritte variiert wird.

5. Verfahren nach einem der Ansprüche 2 bis 4,
**dadurch gekennzeichnet,**
**dass** als Vernetzungsparameter das Verhältnis der Durchmesser von Kanälen (2) der Hydraulikstruktur vor und nach jeder Verzweigung variiert wird.

6. Verfahren nach einem der Ansprüche 2 bis 5,
**dadurch gekennzeichnet,**
**dass** als Vernetzungsparameter Positionen des Fluideintritts- (5) und Fluidaustrittspunktes (6) variiert werden.

7. Verfahren nach einem der Ansprüche 2 bis 6,
**dadurch gekennzeichnet,**
**dass** als Vernetzungsparameter eine Schrittweite variiert wird, auf deren Basis die Pfade (7, 10) gelegt und die Verzweigungsstartpunkte (8) und - endpunkte (9) festgelegt werden.

8. Verfahren nach einem der Ansprüche 1 bis 7,
**dadurch gekennzeichnet,**
**dass** die Durchmesser von Kanälen der Hydraulikstruktur nach jeder Verzweigung so gewählt werden, dass sich ein durch die Verzweigung geleiteter Volumenstrom eines Fluids zu gleichen Teilen auf die Kanäle aufteilt.

9. Verfahren nach einem der Ansprüche 1 bis 8 für die Erstellung eines Hydraulik-Netzwerkes zur Wärmeübertragung in Sonnenkollektoren.

## Claims

1. A method for creating a hydraulic network for realizing a heat and/or material transfer, wherein a given transfer area (1) or a given transfer volume is provided with a multibranched hydraulic network,
**characterized in**
**that** the course of the hydraulic network is defined by the following steps:
- establishing a fluid intake point (5) and a fluid outlet point (6);
- installing a first path (7) between the fluid intake point (5) and the fluid outlet point (6) with approximately identical spacing referred to lateral borders (11) of the transfer area (1) or the transfer volume;
- establishing first branch starting points (8) and end points (9) in a first iteration step at locations of the first path (7), at which a given maximum spacing referred to the lateral borders (11) is exceeded or a given minimum spacing is not reached;
- connecting the first branch starting points (8) and end points (9) by respectively installing at least two second paths (10) with approximately identical spacing referred to the next closest lateral borders (11) of the transfer area (1) or the transfer volume and the first path (7);
- establishing additional branch starting points (8) and end points (9) in an additional iteration step at locations of the most recently installed paths (10), at which a given maximum spacing referred to the next closest lateral borders (11) of the transfer area (1) or the transfer volume is exceeded or a given minimum spacing is not reached;
- connecting the additional branch starting points (8) and end points (9) by respectively installing at least two additional paths (10) with approximately identical spacing referred to the next closest lateral borders (11) of the transfer area (1) or the transfer volume and the next closest path (7, 10) installed so far; and
- repeating the additional iteration step until a given number of iteration steps or a given minimum spacing of the most recently installed paths referred to the next closest borders (11) of the transfer area (1) or the transfer volume is reached;
wherein the respective paths (10) installed in the last iteration step, as well as their connection to the fluid intake point (5) and the fluid outlet point (6) via sections of the paths installed so far, define the structure of the hydraulic network after the iteration steps are completed.

2. The method according to claim 1,
**characterized in**
**that** an optimization method is used in which one or more networking parameters of the hydraulic network are varied in order to obtain optimal networking parameters for establishing the course and the dimensions of hydraulic networks for specific applications.

3. The method according to claim 2,
**characterized in**
**that** the varied networking parameters consist of the minimum and the maximum spacing.

4. The method according to claim 2 or 3,
**characterized in**
**that** the varied networking parameter consists of the number of iteration steps.

5. The method according to one of claims 2-4,
**characterized in**
**that** the varied networking parameter consists of the ratio between the respective diameters of channels (2) of the hydraulic structure upstream and downstream of each branch.

6. The method according to one of claims 2-5,
**characterized in**
**that** the varied networking parameters consist of the positions of the fluid intake point (5) and the fluid outlet point (6).

7. The method according to one of claims 2-6,
**characterized in**
**that** the varied networking parameter consists of an incrementation, on the basis of which the paths (7, 10) are installed and the branch starting points (8) and end points (9) are established.

8. The method according to one of claims 1-7,
**characterized in**
**that** the diameters of channels of the hydraulic structure downstream of each branch are chosen such that a volume flow of a fluid being conveyed through the branch is equally divided over the channels.

9. The method according to one of claims 1-8 for creating a hydraulic network for the heat transfer in solar collectors.

## Revendications

1. Procédé de création d'un réseau hydraulique pour la transmission de chaleur et/ou de matières, au cours duquel on munit une surface de transmission prédéfinie (1) ou un volume de transmission prédéfini d'un réseau hydraulique à ramifications multiples,
**caractérisé en ce que**
le tracé du réseau hydraulique est déterminé par les étapes suivantes :
- détermination d'un point d'entrée du fluide (5) et d'un point de sortie du fluide (6) ;
- pose d'un premier chemin (7) entre le point d'entrée (5) et le point de sortie du fluide (6) avec une distance approximativement identique par rapport à des délimitations latérales (11) de la surface de transmission (1) ou du volume de transmission ;
- détermination de premiers points de départ (8) et d'arrivée (9) des ramifications sur des emplacements du premier chemin (7), sur lesquels une distance maximale prédéfinissable par rapport aux délimitations latérales (11) est dépassée ou une distance minimale prédéfinissable n'est pas atteinte, au cours d'une première étape d'itération ;
- liaison des premiers points de départ (8) et d'arrivée (9) des ramifications par pose de respectivement deux deuxièmes chemins (10) présentant une distance approximativement identique entre les délimitations latérales (11) les plus proches de la surface de transmission (1) ou du volume de transmission et le premier chemin (7) ;
- détermination de points de départs (8) et de points d'arrivée (9) de ramifications supplémentaires sur des emplacements des chemins (10) placés respectivement directement à l'avant, sur lesquels une distance maximale prédéfinissable par rapport aux délimitations latérales (11) les plus proches de la surface de transmission (1) ou du volume de transmission est dépassée ou une distance minimale prédéfinissable n'est pas atteinte, au cours d'une étape d'itération suivante ;
- liaison des points supplémentaires de départ (8) et d'arrivée 9) des ramifications par pose de respectivement au moins deux chemins supplémentaires (10) présentant approximativement la même distance entre des délimitations les plus proches (11) de la surface de transmission (1) ou du volume de transmission et un chemin les plus proche parmi les chemins (7, 10) qui ont été posés précédemment ; et
- répétition de l'étape d'itération supplémentaire jusqu'à l'obtention d'un nombre prédéfinissable d'étapes d'itération ou d'une distance minimale prédéfinissable entre les chemins posés en dernier lieu et les délimitations les plus proches (11) de la surface de transmission (1) ou du volume de transmission ;
après achèvement des étapes d'itération, les chemins (10) respectivement posés lors de la dernière étape d'itération, ainsi que leur liaison avec le point d'entrée (5) et le point de sortie (6) du fluide sur des parties des chemins posés jusqu'à présent déterminant la structure du réseau hydraulique.

2. Procédé selon la revendication 1,
**caractérisé en ce qu'**on utilise un procédé d'optimisation, au cours duquel on varie un ou plusieurs paramètres de réticulation du réseau hydraulique, pour obtenir des paramètres de réticulation optimaux pour des applications prédéfinies pour la détermination du tracé et du dimensionnement du réseau hydraulique.

3. Procédé selon la revendication 2,
**caractérisé en ce qu'**on varie les distances minimales et maximales en tant que paramètres de réticulation.

4. Procédé selon la revendication 2 ou 3,
**caractérisé en ce qu'**on varie le nombre d'étapes d'itération en tant que paramètre de réticulation.

5. Procédé selon l'une quelconque des revendications 2 à 4,
**caractérisé en ce qu'**on varie le rapport entre les diamètres des canalisations (2) de la structure hydraulique avant et après chaque ramification en tant que paramètre de réticulation.

6. Procédé selon l'une quelconque des revendications 2 à 5, **caractérisé en ce qu'**on varie les positions des points d'entrée (5) et de sortie (6) des fluides en tant que paramètres de réticulation.

7. Procédé selon l'une quelconque des revendications 2 à 6, **caractérisé en ce qu'**on varie en tant que paramètre de réticulation un incrément, sur la base duquel on pose les chemins (7, 10) et on détermine les points de départ (8) et d'arrivée (9) des ramifications.

8. Procédé selon l'une quelconque des revendications 1 à 7, **caractérisé en ce qu'**on choisit les diamètres des canalisations de la structure hydraulique après chaque ramification, de façon à ce qu'un débit volumétrique d'un fluide dirigé par la ramification se divise en parties égales sur les canalisations.

9. Procédé selon l'une quelconque des revendications 1 à 8 pour la création d'un réseau hydraulique pour la transmission de chaleur dans des collecteurs solaires.
